# EUROPEAN PATENT SPECIFICATION

(11) **EP 0 469 252 B1**
(45) Date of publication and mention of the grant of the patent: **21.01.1998**
(21) Application number: 91107383.1
(22) Date of filing: 07.05.1991
(51) Int. Cl.: G06F 11/20, G11C 29/00

(54) **Laser link decoder for DRAM redundancy scheme**
Laserstreckendecodierer für DRAM-Redundanzschema
Décodeur à trajet de laser pour schéma de redondance de DRAM

(30) Priority: 19.06.1990 US 540254
(43) Date of publication of application: 05.02.1992
(73) Proprietor: TEXAS INSTRUMENTS INCORPORATED, Dallas Texas 75265 (US)
(72) Inventor: Tran, Hiep V., Carrollton, Texas 75007 (US)
(74) Representative: Leiser, Gottfried, Dipl.-Ing.

(56) References cited:
- EP-A- 0 083 212
- EP-A- 0 098 079
- EP-A- 0 114 763
- EP-A- 0 213 044

## Description

### FIELD OF THE INVENTION

This invention is in the field of integrated circuits and is specifically directed to memories having a redundancy decoder.

### BACKGROUND OF THE INVENTION

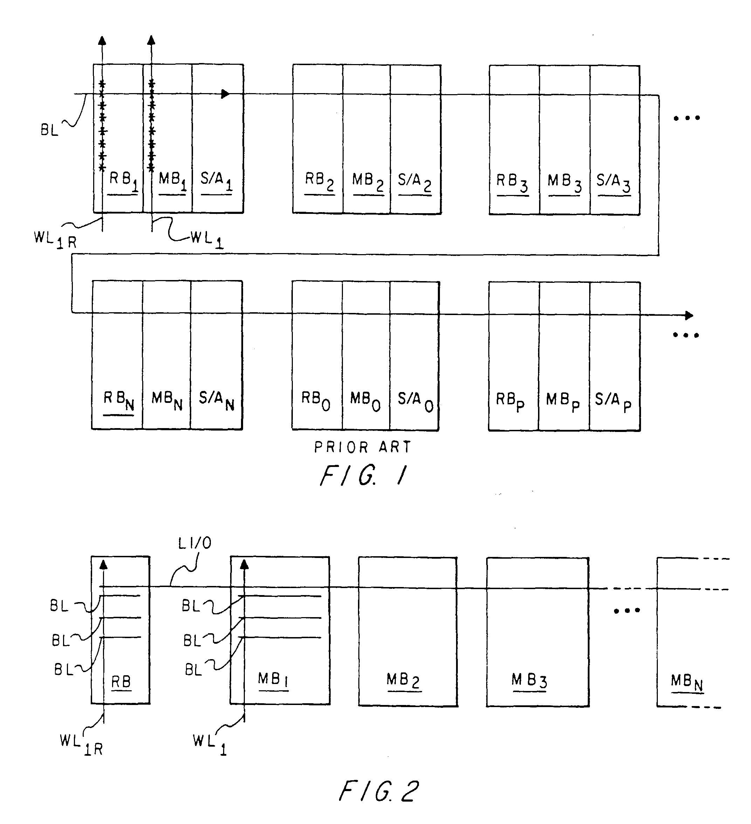

Figure 1 illustrates a schematic drawing of a prior art dynamic random access memory (DRAM) redundancy scheme which includes each memory block, labelled MB with an identifying subscript, and a plurality of redundant blocks of memory, RB, each associated with a memory block and carrying the same subscript. Each redundant block of memory RB and its associated memory block MB share bit lines (each bit line represented as BL). A plurality of sense amplifiers is also shown in Figure 1 with each sense amplifier S/A (hereinafter referred to as sense amp) lying adjacent to and carrying the same subscript as its associated memory block. Redundant blocks of memory serve to provide alternate memory service. For instance, if word line WL₁ or a memory cell along word line WL₁ in memory block MB₁ is defective, word line WR_{1R} in redundant memory block RB₁ is used along with its row (illustrated as vertical columns) of memory cells (each asterisk representing a memory cell).

Published European Patent Application 0,114,763 A2 discloses a redundancy decoder for connection between redundant rows of memory cells of a memory array. The decoder includes a plurality of transistors connected between a signal line and a ground terminal. The transistors are separated from the ground terminal by fuses. However, the transistors are connected in parallel. This makes it necessary to blow each of the fuses corresponding to the address of the redundant row.

### OBJECTS OF THE INVENTION

It is an object of the invention to provide a new and improved decoder.

It is another object of the invention to provide a new and improved decoder for a memory redundancy scheme.

These and other objects of the invention together with the features and advantages thereof will become apparent from the following detailed specification when read together with the accompanying drawings in which applicable reference numerals have been carried forward.

### SUMMARY OF THE INVENTION

According to the present invention there is provided a row redundancy decoder comprising a first and second plurality of transistors, each transistor having one current guiding terminal connected to a common signal line and the other current guiding terminal to a ground plane, a plurality of input circuits each connected to a control terminal of an associated one of said first and second plurality of transistors, each transistor being operable in response to a signal applied by an associated one of said input circuits, and a plurality of fusible elements which are serially connected together, each fusible element from said plurality being connected to a current guiding terminal of an associated one of said first plurality of transistors, wherein at least one fusible element is connected to the common signal line.

The foregoing objects of the invention are accomplished by decoders comprised of a series of transistors which receive a subcircuit input. Each subcircuit contains a fuse which is set corresponding to a particular address state (i.e. either 1 or 0). Consequently, the decoders are responsive to a particular address. The decoders are connected via a common line to its transistors which achieves a necessary state when the current address which is input bit-by-bit to a corresponding subcircuit, matches an address for which main memory replacement has been determined. The common line in its necessary state can activate drivers for activating the redundant replacement memory. Each decoder also contains a plurality of fuses associated with a portion of its transistors which can be set in such a manner so as to result in replacement of a segment of all memory locations preceding the current address.

### BRIEF DESCRIPTION OF THE DRAWINGS

Figure 1 illustrates a schematic drawing of a prior art dynamic random access memory (DRAM) redundancy scheme.

Figure 2 illustrates a schematic drawing of a first preferred DRAM redundancy scheme using the invention's redundancy decoder.

Figure 3 illustrates a diagram of a first preferred layout implementing a 64 megabit DRAM using the invention's redundancy decoder with exploded views of selected components.

Figure 4 illustrates a diagram of a second preferred layout alternative to that shown in figure 3 implementing a 64 megabit DRAM using the invention's redundancy decoder.

Figure 5 illustrates a diagram of one possible scheme showing the use of the signal bits in selecting word lines for refresh.

Figure 6 illustrates a block diagram of the row redundancy scheme.

Figure 7 illustrates a schematic drawing of a row redundancy laser link decoder according to the present invention.

### DETAILED DESCRIPTION OF THE INVENTION

Figure 2 illustrates a schematic drawing of a first preferred DRAM redundancy scheme using the invention's redundancy decoder. As shown, only one redundant block of memory RB is required for a plurality of memory blocks. An arrangement of this kind is known e.g. from EP-A-083 212. Redundant block of memory RB has its own independent bit lines (each labeled BL) unlike that of the prior art in which bit lines of the redundant block and its associated memory block are shared. Here, local input/output (L I/O) data line is shared by redundant block of memory RB and a plurality of memory blocks MB. If there is a defect associated with word line WL₁ in memory block MB₁, then word line WL_{1R} from the redundant block is used along with its associated memory cells in redundant block RB. Alternatively, any word line and memory cells from any of the other blocks can be replaced through the use of redundant block RB. The number of wordlines and associated circuitry (i.e. memory cells) which can be corrected depends on the number of word lines and associated circuitry in the redundant block. Thus, if the redundant block has 5 rows of memory cells, 5 wordlines and their associated cells can be corrected from any of the memory blocks.

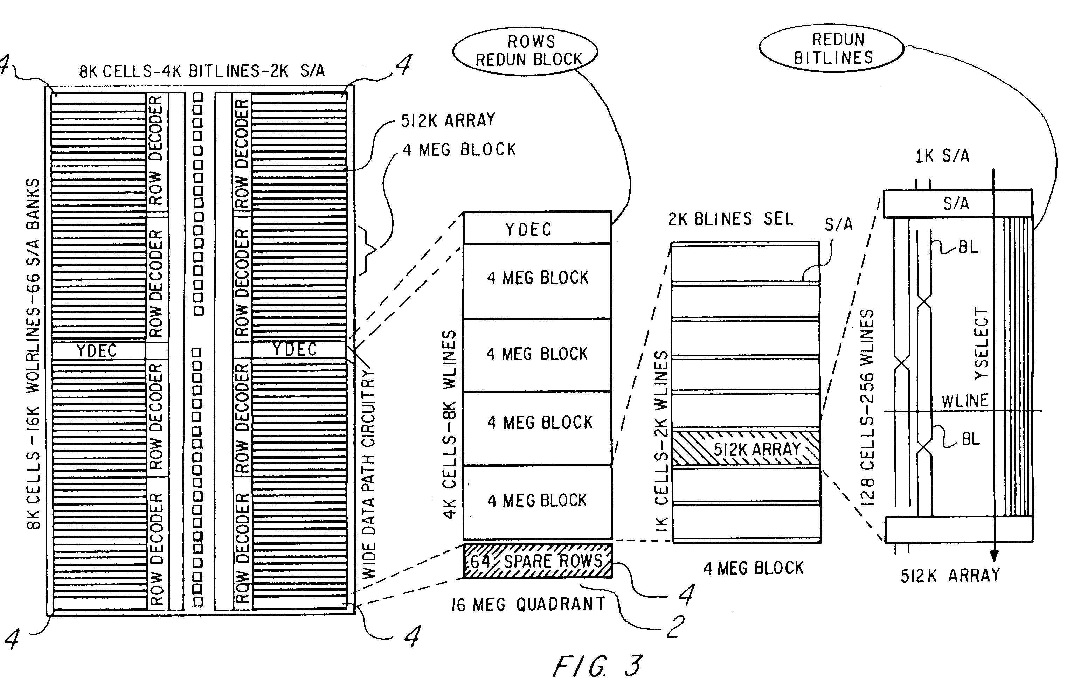

Figure 3 illustrates a diagram of a first preferred layout implementing a 64 megabit DRAM using the invention's redundancy decoder with exploded views of selected components. There are 8000 (8k) memory cells, 16,000 (16k) word lines, and 2000 (2k) sense amps (S/A) in the 64 meg DRAM of figure 3 . As illustrated, an exploded view of a section along the dashed line details one 16 megabit quadrant 2. There are 4000 (4K) memory cells and 8000 (8K) word lines in each 16 meg quadrant. Note that a block of redundant rows 4 exists for each 16 megabit quadrant of memory. In this example, there are 64 redundant rows of memory in each block of redundant rows 4. Each 16 megabit quadrant 2 is partitioned into four 4 megabit (4 meg) memory blocks with each block including four 512 kilobit (512k) memory arrays. As shown, another exploded view of memory along dashed lines details a 4 meg block of memory. For ease of illustration, onLy one 512k array is labeled along with a section of sense amplifiers S/A. A section of sense amplifiers abuts each array. There are 1000 (1k) memory cells and 2000 (2k) word lines in each 4 meg block. The number of bit lines in a 4 meg block is on the order of 2000. The labeled 512k array and its associated sense amplifiers S/A are exploded into a more detailed view in which bit lines BLs are of the twisted variety. There are 128 memory cells and 256 word lines in each 512k array. Word line WLINE and bit line YSELECT indicate a word line and a bit line respectively, selected by a respective row decoder and column decoder YDEC. The intersection of a bit line with a word line as shown indicates the location of a chosen memory cell. The small section of closely spaced vertical lines labeled REDUN BITLINES indicates the bit lines for the redundant memory cells. Bond pads 3 for the address, control, and input/output (I/O) are represented by the small squares down the middle of chip 2. The location of wide data path circuitry is indicated as shown.

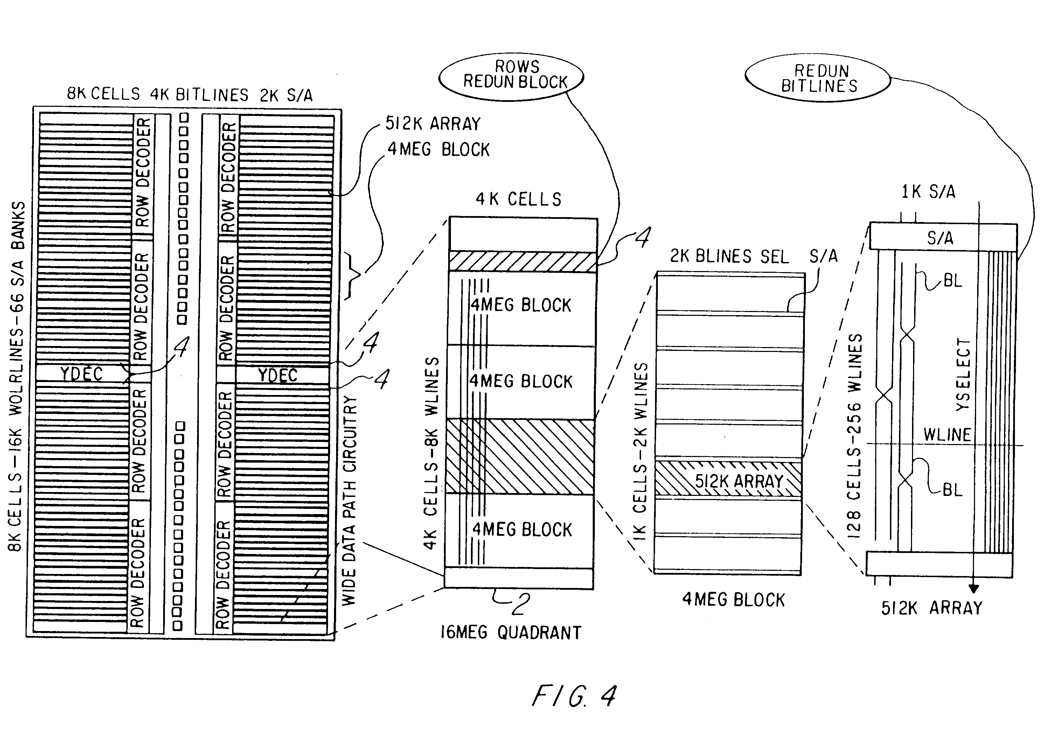

A second preferred layout alternative to that shown in figure 3 implementing a 64 megabit DRAM using the invention's redundancy decoder is illustrated in the diagram in figure 4. The position of the redundant blocks differs from that shown in figure 3. Note that the redundant blocks are near the column decoders (YDEC). This positioning of the redundant blocks near the column decoders can increase the operating speed of the memory.

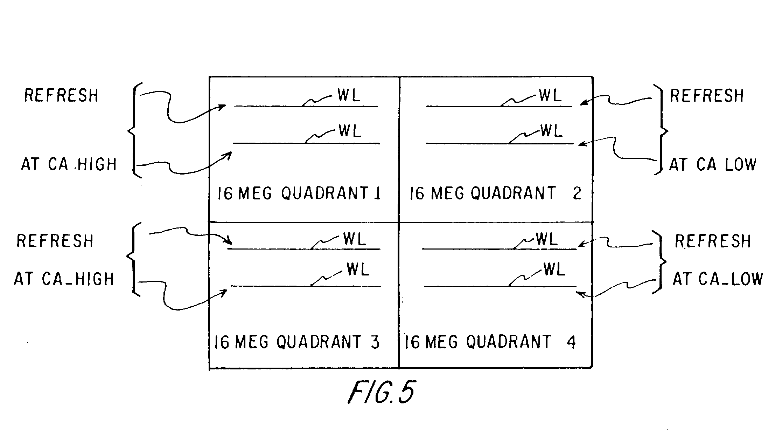

Memory cells of a DRAM must be refreshed to prevent loss of data. Generally, this is accomplished by the word line of a cell being energized so as to allow the cell's bit line to reinsert data to the cell via a sense amplifier. Refresh of a memory cell is required after reading data out of the cell. Refresh is also routinely required to prevent loss of memory storage through capacitor leakage. The refresh operation of the preferred embodiment of the 64 meg DRAM is such that 8k of memory cells are refreshed at a time. This translates into four word lines (2k memory cells on each word line) on the 64 meg chip being refreshed at the same time. Column address program (CA PROG) provides a signal bit either CA or CA_ which allows the selection of four word lines for refresh including any word lines from which the data of an associated cell is desired. Figure 5 illustrates a diagram of one possible scheme showing the use of the signal bits in selecting word lines for refresh. Memory cells of two word lines from a pair of diagonally positioned 16 meg qaudrants are refreshed. For instance, when signal bit CA is logic high, signal bit CA_, its complement, is logic low. Consequently, in the scheme shown in figure 5, two word lines in 16 meg quadrant 1 are refreshed along with two word lines in 16 meg quadrant 4. Alternatively, when signal bit CA_ is logic high, its complement, signal bit CA is logic low, thereby resulting in two word lines in both 16 meg quadrants 2 and 3 being refreshed. In either of the cases given above concerning the logic states of signal bits CA and CA_, one of the word lines for a cell selected for refresh will be a word line for a cell selected for reading information therefrom. Refresh of the cells of the selected word line occurs after the selected cell information has been read. Should the row address of a selected cell correspond to an address identified by circuitry (not shown) as having a defective word line, then replacement of the cell with a cell of a redundant word line takes place in accordance with the following description.

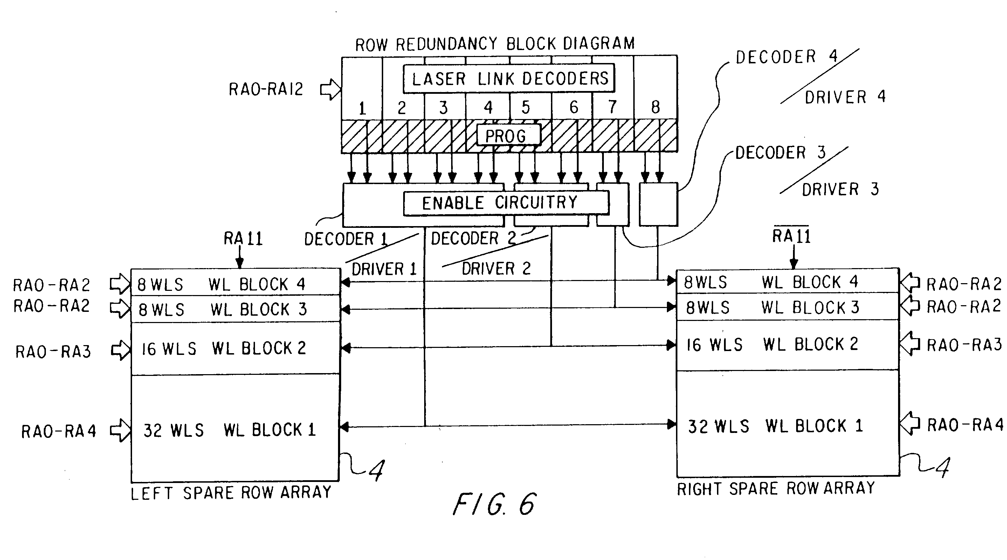

Figure 6 illustrates a block diagram of the row redundancy scheme. As shown, redundant rows 4, referenced respectively as left and right spare row arrays are each divided into 2 groups of 8 word lines (WLs), 1 group of 16 WLs, and 1 group of 32 WLs. Enable circuitry comprising decoders labeled 1, 2, 3, and 4, enables redundant word line blocks labeled 1, 2, 3, and 4 to provide replacement for word line rows of memory within the 4 meg blocks based on signals received from a plurality of laser link decoders. Alternatively, instead of decoders, enable circuitry can comprise drivers, whereby redundant row selection in spare row arrays is determined by the plurality of laser link decoders. Although only 8 laser link decoders are illustrated in figure 6, fewer or more may be used. The redundant memory along word lines are addressable by a portion of the address from the non redundant or rather main memory array. Thus, although the current address from main memory is for instance, 12 bits long, the redundant memory can for instance be addressed by 2 to 4 bits which can reflect the least significant 2 to 4 bits in the 12 bit long current address. Word line block 1 comprises 32 word lines addressable by row addresses RA0 to RA1. Word line block 2 comprises 16 word lines addressable by row addresses RA0 to RA3. Word line block 3 comprises 8 word lines addressable by row addresses RA0 to RA2. Word line block 4 comprises 8 word lines addressable by row addresses RA0 to RA2. As a consequence of the above discussed addressability, should for instance, rows 3-10 of a first 4 meg block be defective, either of laser link decoders 1 to 4 could provide replacement of these defective rows with the available 32 word line rows of redundant memory in redundant block 1 addressed by RA0-RA4. If, for instance, in addition to the defective rows 3-10 of the first block, rows 3-10 of a second 4 meg block are defective, decoders 5 or 6 can provide replacement of the defective rows in the second block with redundant rows from the available 16 word line rows of redundant memory in redundant block 2 addressed by RA0-RA3. Further, if rows 3-10 of a third 4 meg block are additionally defective, decoder 7 can provide replacement of the defective rows in the third block with redundant rows from the available 8 word line rows of redundant memory in redundant block 3 addressed by RA0-RA2. If in addition to the defective rows 3-10 in the first, second and third blocks, rows 3-10 in a fourth 4 meg block of memory are defective, decoder 8 can provide replacement of the defective rows in the fourth block of memory with redundant rows from the available 8 word line rows of redundant memory in redundant block 4 addressed by RA0-RA2. As shown, redundant word line blocks are in either a right or left spare row array. A right or left spare row selection is determined by row address RA11 and its complement RA11_ such that a high signal on an address bit indicates selection of a corresponding spare row array. An optimal replacement scheme for the memory can be determined by a computer program 9 (represented in figure 6 as PROG) using linear programming or other techniques. Alternatively, a computer program is not necessary to implement this aspect of the invention. Therefore, a human operator can determine the order of replacement.

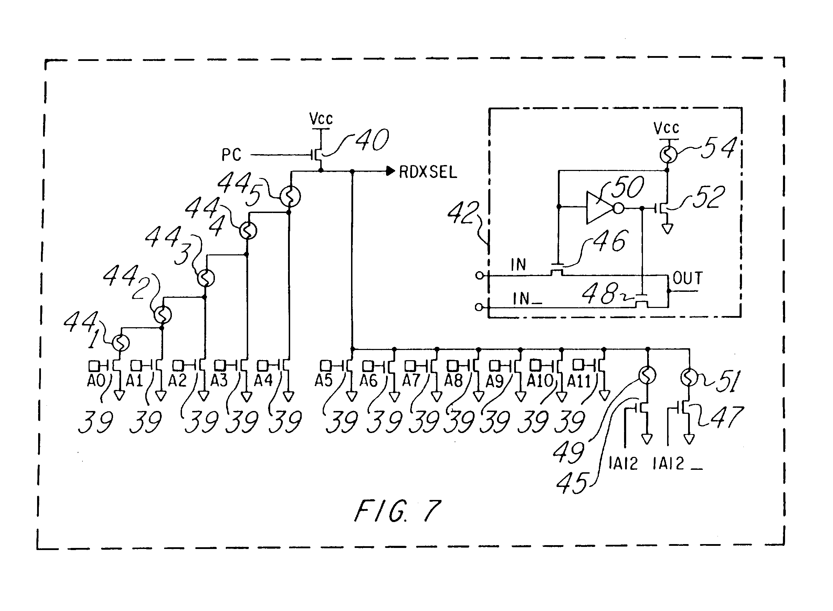

Figure 7 illustrates a schematic drawing of a row redundancy laser link decoder. A plurality of n-channel field effect transistors, each labeled 39, are coupled to and between redundancy select signal line RDXSEL and circuit ground. Alternatively, p-channel field effect transistors can be sused in place of each transistor 39. Still alternatively, bipolar transistors can be used in place of transistors 39 with a base connection substituted for the gate connection together with collector emitter connections substituted for some combinations of drain and source connections. Decoder subcircuits, each label A followed by a number, are connected to the gate of an associated transistor 39. P-channel precharge transistor 40 is connected at its source to circuit supply voltage Vcc, while its drain is connected to line RDXSEL. Precharge signal PC is delivered to the gate of transistor 40. Precharge signal PC turns on transistor 40, resulting in precharging line RDXSEL to a logic high level. Fuse 44 is connected to and between the drains of adjacent transistors including transistors 39 and transistor 40. Transistors 45 and 47 are connected to ground and are each coupled to line RDXSEL through fuses 49 and 51 respectively. Note that transistors 45 and 47 along with their respective fuses 49 and 51, can be configured so as to deactivate a particular decoder by bringing its RDXSEL line low. Inputs to transistors 45 and 47 are labeled IA12 and IA12_. Square 42 in figure 7 illustrates a blown-up view of a representative decoder subcircuit A. As shown in square 42, each subcircuit A has an output OUT and inputs, IN and IN_ which are connected to respective n-channel transistors 46 and 48. Each output OUT of subcircuit A is connected to an associated gate of one of the transistors labeled 39. The gate of transistor 46 is connected to the input of inverter 50 while the gate of transistor 48 is connected to the output of inverter 50. The gate of transistor 52 is connected to the output of inverter 50. The drain of pull-down n-channel transistor 52 is coupled to supply voltage Vcc through fuse 54 and it is connected to the input of inverter 50 and the gate of transistor 46. Fuses 54 of subcircuit A are blown corresponding to the binary ones of the address of the row of memory requiring replacement. A signal corresponding to a binary address bit along with a signal corresponding to the complement of the address bit is supplied to inputs IN and IN_, respectively, of an associated subcircuit A. A logic high signal corresponds to a logic 1 bit while a logic low signal corresponds to a logic 0 bit. 2¹² memory locations are indicated by figure 7, with a signal corresponding to the least significant bit of an address being transmitted to subcircuit A0, and with each signal corresponding to a succeeding bit being transmitted to subcircuit A of a unit increment increase in the numerical portion of its label. For instance, a signal corresponding to the 12th bit of an address, along with a signal corresponding to the complement of the 12th bit of an address would be transmitted to inputs IN and IN_, respectively of subcircuit A11. Similarly, a signal corresponding to the 5th bit of an address, along with a signal corresponding to the complement of the 5th bit of an address would be transmitted to inputs IN and IN_ of subcircuit A4. Signals corresponding to all of the addresses of, for instance, a 16 megabit quadrant of memory are transmitted to the inputs of the A subcircuits in the manner set forth above.

If a high signal is sent to input IN and fuse 54 of the associated subcircuit A is not blown, inverter 50 keeps transistor 48 off, thus preventing the logic low signal at input IN_ from getting to output OUT. Additionally, transistor 52 is kept turned off. The logic high signal at input IN is transmitted to output OUT and transistor 39 connected to subcircuit A at its gate, pulls line RDXSEL down in voltage from its precharged level, thus indicating that the row of the current address (whose corresponding signals are now being input into subcircuits A) does not need replacement. A logic low signal at input IN of a subcircuit A whose fuse 54 is not blown results in transistors 48 and 52 being shut off. The logic low signal will be passed to output OUT, thus resulting in not pulling line RDXSEL down in voltage. This is a condition, as will be explained further below, which can lead to the replacement of a row by a redundant row. If however, fuse 54 of a subcircuit A is blown, a logic high signal at input IN of that subcircuit A, is not transmitted to output OUT since transistor 46 will be turned off due to the termination of the connection between voltage Vcc and its gate Inverter 50 will turn on transistor 48 to allow transmission of the signal at input IN_ (in this case a logic low) to reach output OUT, resulting in not pulling line RDXSEL down. Furthermore, should a fuse 54 be blown, if any of the signals at IN_ is logic high (or rather a signal at input IN is logic low) , a transistor 39 connected by its gate to the output of the subcircuit A with the logic high input IN_ signal will pull line RDXSEL low, thus indicating no need for replacement of a row corresponding to the current row address.

If line RDXSEL remains high after input of signals, corresponding to a row address, to the A subcircuits, this is sufficient to indicate that the row of the current row address needs replacement by the redundant row associated with the present row redundancy laser link decoder. Should two or more rows in a block need replacement, a fuse 44 can be blown so as to allow the decoder to select redundant rows of memory for the defective rows, all preceding rows thereof, all subsequent rows up to an additional most significant bit address, and all intervening rows therebetween. Thus, if the third and the tenth row of a block needed replacement with a redundant row, fuse 44₄ is blown and redundant rows are selected to replace rows 1 through 31. Additionally, the redundant replacement scheme discussed with regard to figure 6 can be implemented for use in replacement of memory anywhere within a main memory array. For instance, although it is possible to replace the first 32 rows in a main memory block by blowing fuse 44₅, it is possible to replace other groups of 32 rows of memory depending upon the address identified as defective in the laser link decoder. For example, laser link decoder 3 may identify the 1035th address as defective. If in addition to this defective address, there exist other addresses in close proximity which are defective, fuse 44₅ can be blown so as to allow replacement of the 1003rd to 1035th rows of memory.

Although the invention has been described in detail herein with reference to its preferred embodiment, it is to be understood that this description is by way of example only and is not to be construed in a limiting sense. It is to be further understood that numerous changes in the details of the embodiments of the invention, and additional embodiments of the invention, will be apparent to, and may be made by persons of ordinary skill in the art having reference to this description. For instance, although the foregoing invention has been described with regard to a DRAM, it may be used as a redundancy scheme for any memory including read only memories and static random access memories. Further, p-channel transitors, n-channel transistors, and bipolar transistors (n-type or p-type) can be substituted for each other throughout. Additionally, although fuses which are capable of being blown by lasers are discussed other types of fuses are contemplated, such as electrically blown fuses. It is contemplated that all such changes and additional embodiments are within the scope of the invention as claimed below.

## Claims

1. A row redundancy decoder comprising:
a first and second plurality of transistors (39), each transistor (39) having one current guiding terminal connected to a common signal line (RDXSEL) and the other current guiding terminal to a ground plane;
a plurality of input circuits (A0 - A12) each connected to a control terminal of an associated one of said first and second plurality of transistors (39), each transistor (39) being operable in response to a signal applied by an associated one of said input circuits (A0 - A12); and
a plurality of fusible elements (44) which are serially connected together, each fusible element from said plurality being further connected to a current guiding terminal of an associated one of said first plurality of transistors (39), wherein at least one fusible element (44) is connected to the common signal line (RDXSEL).

2. A decoder as claimed in claim 1, further comprising precharge circuitry (40) for connection to said signal line (RDXSEL).

3. A decoder as claimed in claims 1 - 2, wherein each input circuit (A0 - A12) is selectively arranged to apply a signal to the first and second plurality of transistors (39), the signal corresponding to the address of a row of memory cells for replacement.

4. A decoder as claimed in any preceding claim and further including:
circuitry for disabling said decoder, comprising a pair of fuses (49, 51) connected between said signal line (RDXSEL) and a current guiding terminal of an associated one of a pair of transistors (45, 47); and
each transistor (45, 47) further having a current guiding terminal connected to said ground plane and being operable to receive the complement of an input signal to the other of said pair of transistors at a gate control terminal.

5. A decoder as claimed in any preceding claim, wherein each fusible element (44) is capable of being blown by a laser.

6. A decoder as claimed in any preceding claim, wherein each transistor (39) is an n-channel transistor.

7. A decoder as claimed in any preceding claim, wherein each transistor (39) is a bipolar transistor.

8. A decoder as claimed in any preceding claim, wherein each transistor (39) is a p-channel transistor.

## Patentansprüche

1. Zeilenredundanzdecodierer, mit:
einer ersten Mehrzahl und einer zweiten Mehrzahl von Transistoren (39), wobei jeder Transistor (39) einen Stromführungsanschluß besitzt, der an eine gemeinsame Signalleitung (RDXSEL) angeschlossen ist, während der andere Stromführungsanschluß an eine Masseebene angeschlossen ist; mehreren Eingangsschaltungen (A0-A12), wovon jede an einen Steueranschluß eines zugeordneten Transistors (39) der ersten und der zweiten Mehrzahl von Transistoren (39) angeschlossen ist, wobei jeder Transistor (39) als Antwort auf ein Signal, das durch eine zugeordnete der Eingangsschaltungen (A0-A12) angelegt wird, betrieben werden kann; und
mehreren schmelzbaren Elementen (44), die in Serie geschaltet sind, wobei jedes schmelzbare Element der Mehrzahl ferner an einen Stromführungsanschluß eines zugeordneten Transistors (39) der ersten Mehrzahl von Transistoren (39) angeschlossen ist, wobei wenigstens ein schmelzbares Element (44) an die gemeinsame Signalleitung (RDXSEL) angeschlossen ist.

2. Decodierer nach Anspruch 1, ferner mit einer Vorladungsschaltungsanordnung (40), die an die Signalleitung (RDXSEL) angeschlossen ist.

3. Decodierer nach den Ansprüchen 1-2, wobei jede Eingangsschaltung (A0-A12) so beschaffen ist, daß sie ein Signal an die erste Mehrzahl und an die zweite Mehrzahl von Transistoren (39) wahlweise anlegt, wobei das Signal der Adresse einer Zeile von zu ersetzenden Speicherzellen entspricht.

4. Decodierer nach irgendeinem vorangehenden Anspruch und ferner mit:
einer Schaltungsanordnung zum Sperren des Decodierers, mit einem Paar von Sicherungen (49, 51), die zwischen die Signalleitung (RDXSEL) und inen Stromführungsanschluß eines zugeordneten eines Paars von Transistoren (45, 47) geschaltet sind; und
wobei jeder Transistor (45, 47) ferner einen an die Masseebene angeschlossenen Stromführungsanschluß besitzt und so betreibbar ist, daß er das Komplement eines an den anderen des Paars von Transistoren angelegten Eingangssignals an einem Gatesteueranschluß empfängt.

5. Decodierer nach irgendeinem vorangehenden Anspruch, wobei jedes schmelzbare Element (44) durch einen Laser ausgelöst werden kann.

6. Decodierer nach irgendeinem vorangehenden Anspruch, wobei jeder Transistor (39) ein n-Kanal-Transistor ist.

7. Decodierer nach irgendeinem vorangehenden Anspruch, wobei jeder Transistor (39) ein Bipolartransistor ist.

8. Decodierer nach irgendeinem vorangehenden Anspruch, wobei jeder Transistor (39) ein p-Kanal-Transistor ist.

## Revendications

1. Décodeur à redondance de lignes comprenant :
des première et seconde pluralités de transistors (39), chaque transistor (39) comportant une borne de guidage du courant connectée à une ligne commune de transmission de signaux (RDXSEL) et dont l'autre borne de guidage du courant est connectée à un plan de masse ;
une pluralité de circuits d'entrée (A0 - A12) connectés chacun à une borne de commande de l'une associée desdites première et seconde pluralités de transistors (39), chaque transistor (39) pouvant agir en réponse à un signal appliqué par l'un associé desdits circuits d'entrée (A0 - A12 ) ; et
une pluralité d'éléments fusibles (44) sont connectés entre eux en série, chaque élément fusible de ladite pluralité étant en outre connecté à une borne de guidage du courant d'un transistor associé faisant partie de ladite pluralité de transistors (39), au moins un élément fusible (44) étant connecté à la ligne commune de transmission de signaux (RDXSEL).

2. Décodeur selon la revendication 1, comprenant un circuit de précharge (40) pour la connexion avec ladite ligne de transmission de signaux (RDXSEL).

3. Décodeur selon les revendications 1 ou 2, dans lequel chaque circuit d'entrée (AO - A12) est agencé sélectivement de manière à appliquer un signal aux première et seconde pluralités de transistors (39), le signal correspondant à l'adresse d'une rangée de cellule de mémoire pour un remplacement.

4. Décodeur selon l'une quelconque des revendications précédentes et comprenant en outre :
un circuit pour invalider ledit décodeur, comprenant un couple de fusibles (49, 51) connectés entre ladite ligne de transmission de signaux (RDXSEL) et une borne de guidage du courant d'un transistor associé faisant partie d'un couple de transistors (45, 47) ; et
chaque transistor (45, 47) comportant en outre une borne de guidage du courant connectée audit plan de masse et pouvant agir de manière à recevoir le complément d'un signal d'entrée envoyé à l'autre transistor dudit couple de transistors au niveau d'une borne de commande de grille.

5. Décodeur selon l'une quelconque des revendications précédentes, dans lequel chaque élément fusible (44) peut être sectionné par un laser.

6. Décodeur selon l'une quelconque des revendications précédentes, dans lequel chaque transistor (39) est un transistor à canal n.

7. Décodeur selon l'une quelconque des revendications précédentes, dans lequel chaque transistor (39) est un transistor bipolaire.

8. Décodeur selon l'une quelconque des revendications précédentes, dans lequel chaque transistor (39) est un transistor à canal p.
